(19) Europäisches Patentamt
European Patent Office
Office européen des brevets

(11) EP 2 674 993 A2

(12) # EUROPEAN PATENT APPLICATION

(43) Date of publication:
**18.12.2013 Bulletin 2013/51**

(21) Application number: **13171016.2**

(22) Date of filing: **07.06.2013**

(51) Int Cl.:
***H01L 33/54*** *(2010.01)* *H01L 33/50* *(2010.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **11.06.2012 JP 2012132238**

(71) Applicant: **NITTO DENKO CORPORATION**
**Ibaraki-shi,**
**Osaka 567-8680 (JP)**

(72) Inventors:
- **Kono, Hiroki**
  **Osaka, 567-8680 (JP)**
- **Kondo, Takashi**
  **Osaka, 567-8680 (JP)**
- **Matsuda, Hirokazu**
  **Osaka, 567-8680 (JP)**

(74) Representative: **HOFFMANN EITLE**
**Patent- und Rechtsanwälte**
**Arabellastrasse 4**
**81925 München (DE)**

(54) **Encapsulating sheet, light emitting diode device, and producing method thereof**

(57) An encapsulating sheet includes an encapsulating resin layer (2) and a barrier film layer (3) formed at one side in a thickness direction of the encapsulating resin layer. In addition a phosphor layer (4) can be at the side of the barrier layer (3).

FIG. 1

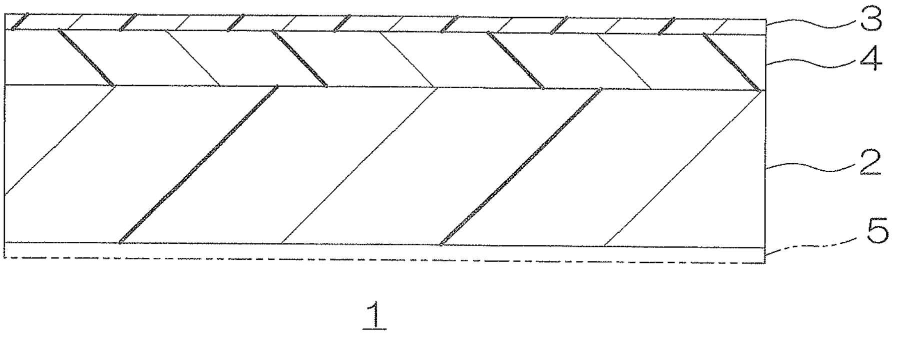




Printed by Jouve, 75001 PARIS (FR)

## Description

CROSS-REFERENCE TO RELATED APPLICATION

The present application claims priority from Japanese Patent Applications No. 2012-132238 filed on June 11, 2012, the contents of which are hereby incorporated by reference into this application.

BACKGROUND OF THE INVENTION

Field of the Invention

The present invention relates to an encapsulating sheet, a light emitting diode device, and a producing method thereof, to be specific, to a light emitting diode device used for an optical use, a producing method thereof, and an encapsulating sheet used in the light emitting diode device and the producing method thereof.

Description of Related Art

Conventionally, as a light emitting device which is capable of emitting high-energy light, a white light emitting device has been known.

In the white light emitting device, for example, blue light is emitted by an optical semiconductor and a part of the emitted blue light is converted into yellow light by a phosphor layer containing a phosphor, so that white light is emitted by color mixing of the blue light and the yellow light.

In recent years, in the white light emitting device, in order to improve the extraction efficiency of light from the optical semiconductor and reduce the angle dependence of color tone, a configuration of separating the phosphor layer from the optical semiconductor has been considered.

As the white light emitting device, for example, a semiconductor light emitting device which includes an LED, a phosphor cover that houses the LED in the internal space thereof, and a resin encapsulating material that fills the space between the LED and the phosphor cover has been proposed (ref: for example, Japanese Unexamined Patent Publication No. 2001-358368).

SUMMARY OF THE INVENTION

However, in the semiconductor light emitting device described in Japanese Unexamined Patent Publication No. 2001-358368, there may be a case where the temperature of the resin encapsulating material is increased by heat generation of the LED and the phosphor cover along with the light emission, so that a bleeding of a residual monomer (an unreacted liquid resin) in the resin encapsulating material occurs. In this way, there is a disadvantage of damaging the appearance of the semiconductor light emitting device.

It is an object of the present invention to provide an encapsulating sheet which is capable of suppressing a bleeding in an encapsulating resin layer, a light emitting diode device in which a light emitting diode element is encapsulated by the encapsulating sheet and the improvement of the appearance is attempted, and a producing method thereof.

An encapsulating sheet of the present invention includes an encapsulating resin layer and a barrier film layer formed at one side in a thickness direction of the encapsulating resin layer.

In the encapsulating sheet of the present invention, it is preferable that the total light absorption coefficient in the thickness direction of the barrier film layer with respect to light at the wavelength of 450 nm is 8 % or less.

In the encapsulating sheet of the present invention, it is preferable that the thickness of the barrier film layer is less than 200 $\mu$m.

In the encapsulating sheet of the present invention, it is preferable that the encapsulating sheet further includes a phosphor layer which is formed so as to be adjacent to the barrier film layer.

In the encapsulating sheet of the present invention, it is preferable that the barrier film layer is formed at one side in the thickness direction with respect to the phosphor layer.

A method for producing a light emitting diode device of the present invention includes a step of encapsulating a light emitting diode element by embedding the light emitting diode element which is mounted on a board by an encapsulating resin layer in an encapsulating sheet including the encapsulating resin layer and a barrier film layer formed at one side in a thickness direction of the encapsulating resin layer.

A light emitting diode device of the present invention is obtained by a method for producing a light emitting diode device including a step of encapsulating a light emitting diode element by embedding the light emitting diode element which is mounted on a board by an encapsulating resin layer in an encapsulating sheet including the encapsulating resin layer and a barrier film layer formed at one side in a thickness direction of the encapsulating resin layer.

In the encapsulating sheet of the present invention, the barrier film layer is formed at one side in the thickness direction of the encapsulating resin layer.

Therefore, in the light emitting diode device in which the light emitting diode element is encapsulated by the encapsulating sheet of the present invention, even when the light emitting diode element and the encapsulating resin layer generate heat along with the light emission, the bleeding in which the residual monomer (the unreacted liquid resin) in the encapsulating resin layer precipitates toward the one side in the thickness direction can be suppressed by the barrier film layer. As a result, it is possible to improve the appearance of the light emitting diode device.

The light emitting diode device of the present invention is reinforced by the barrier film layer, so that a deformation can be effectively prevented.

BRIEF DESCRIPTION OF THE DRAWINGS

FIG. 1 shows a sectional view of one embodiment of an encapsulating sheet of the present invention.

FIG. 2 shows process drawings for illustrating a method for producing the encapsulating sheet in FIG. 1:

- FIG. 2 (a) illustrating a step of preparing a barrier film layer,
- FIG. 2 (b) illustrating a step of forming a phosphor layer, and
- FIG. 2 (c) illustrating a step of forming an encapsulating resin layer.

FIG. 3 shows process drawings for illustrating one embodiment of a method for producing a light emitting diode device of the present invention in which the light emitting diode device is produced by encapsulating a light emitting diode element by the encapsulating sheet in FIG. 1:

- FIG. 3 (a) illustrating a step of preparing an encapsulating sheet and a board and
- FIG 3 (b) illustrating a step of encapsulating the light emitting diode element using a flat plate press.

FIG. 4 shows process drawings for illustrating another embodiment of a method for producing a light emitting diode device of the present invention in which the light emitting diode device is produced by encapsulating a light emitting diode element by the encapsulating sheet in FIG. 1:

- FIG. 4 (a) illustrating a step of preparing an encapsulating sheet, a board, and a metal mold die and
- FIG. 4 (b) illustrating a step of pressure molding the encapsulating sheet using the metal mold die.

FIG. 5 shows a sectional view of another embodiment (an embodiment in which an encapsulating sheet is formed of a barrier film layer and an encapsulating resin layer) of the encapsulating sheet of the present invention.

FIG. 6 shows a sectional view of another embodiment (an embodiment in which a barrier film layer is interposed between a phosphor layer and an encapsulating resin layer) of the encapsulating sheet of the present invention.

FIG. 7 shows process drawings for illustrating a method for producing a light emitting diode device by encapsulating a light emitting diode element by the encapsulating sheet in FIG. 6:

- FIG. 7 (a) illustrating a step of preparing an encapsulating sheet and a board and
- FIG. 7 (b) illustrating a step of encapsulating the light emitting diode element using a flat plate press.

FIG. 8 shows process drawings for illustrating a method for producing a light emitting diode device by encapsulating a light emitting diode element by the encapsulating sheet in FIG. 6:

- FIG. 8 (a) illustrating a step of preparing an encapsulating sheet, a board, and a metal mold die and
- FIG. 8 (b) illustrating a step of pressure molding the encapsulating sheet using the metal mold die.

DETAILED DESCRIPTION OF THE INVENTION

FIG. 1 shows a sectional view of one embodiment of an encapsulating sheet of the present invention. FIG. 2 shows process drawings for illustrating a method for producing the encapsulating sheet in FIG. 1: FIG. 2 (a) illustrating a step of preparing a barrier film layer, FIG. 2 (b) illustrating a step of forming a phosphor layer, and FIG. 2 (c) illustrating a step of forming an encapsulating resin layer. FIG. 3 shows process drawings for illustrating one embodiment of a method for producing a light emitting diode device of the present invention in which the light emitting diode device is

produced by encapsulating a light emitting diode element by the encapsulating sheet in FIG. 1: FIG. 3 (a) illustrating a step of preparing an encapsulating sheet and a board and FIG 3 (b) illustrating a step of encapsulating the light emitting diode element using a flat plate press.

In FIG. 1, an encapsulating sheet 1 is formed into a generally rectangular shape in sectional view extending in the plane direction (the direction perpendicular to the thickness direction). The encapsulating sheet 1 includes an encapsulating resin layer 2 and a barrier film layer 3 which is formed above (at one side in the thickness direction of) the encapsulating resin layer 2. The encapsulating sheet 1 includes a phosphor layer 4 which is interposed between the encapsulating resin layer 2 and the barrier film layer 3.

The encapsulating resin layer 2 is formed from an encapsulating resin composition into a generally sheet shape. The encapsulating resin layer 2 is provided at the lowest side in the encapsulating sheet 1.

The encapsulating resin composition contains a known transparent resin used in encapsulating a light emitting diode element 7 (described later, ref: FIG. 3 (b)). Examples of the transparent resin include a thermosetting resin such as a silicone resin, an epoxy resin, and a urethane resin and a thermoplastic resin such as an acrylic resin, a styrene resin, a polycarbonate resin, and a polyolefin resin.

These transparent resins can be used alone or in combination.

Of the transparent resins, preferably, a thermosetting resin is used, or more preferably, in view of durability, heat resistance, and light resistance, a silicone resin is used.

Of the encapsulating resin compositions, preferably, a resin composition containing a silicone resin (hereinafter, defined as a silicone resin composition) is used.

Examples of the silicone resin composition include a condensation/addition reaction curable type silicone resin composition, a modified silicone resin composition containing a hetero atom, an addition reaction curable type silicone resin composition, and a silicone resin composition containing an inorganic oxide.

Of the silicone resin compositions, preferably, in view of flexibility of the encapsulating resin layer 2 before curing and strength thereof after curing, a condensation/addition reaction curable type silicone resin composition is used.

The condensation/addition reaction curable type silicone resin composition is a silicone resin composition which can undergo a condensation reaction (to be specific, a silanol condensation reaction) and an addition reaction (to be specific, a hydrosilylation reaction). To be more specific, the condensation/addition reaction curable type silicone resin composition is a silicone resin composition which can be brought into a semi-cured state (a B-stage state) by undergoing the condensation reaction by heating and then, be brought into a cured state (a completely cured state, a C-stage state) by undergoing the addition reaction by further heating.

An example of the condensation reaction includes a silanol condensation reaction. Examples of the addition reaction include an epoxy ring-opening reaction and a hydrosilylation reaction.

The condensation/addition reaction curable type silicone resin composition contains, for example, a polysiloxane containing silanol groups at both ends, a silicon compound containing an ethylenically unsaturated hydrocarbon group (hereinafter, defined as an ethylenic silicon compound), an epoxy group-containing silicon compound, and an organohydrogensiloxane.

The polysiloxane containing silanol groups at both ends, the ethylenic silicon compound, and the epoxy group-containing silicon compound are condensation materials (materials subjected to the condensation reaction). The ethylenic silicon compound and the organohydrogensiloxane are addition materials (materials subjected to the addition reaction).

The polysiloxane containing silanol groups at both ends is an organosiloxane which contains silanol groups (SiOH groups) at both ends of a molecule and to be specific, is represented by the following general formula (1).

General Formula (1):

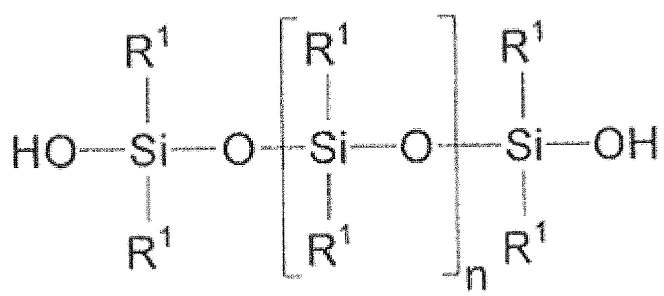

(1)

(where, in general formula (1), $R^1$ represents a monovalent hydrocarbon group selected from a saturated hydrocarbon group and an aromatic hydrocarbon group. "n" represents an integer of 1 or more.)

In the above-described general formula (1), in the monovalent hydrocarbon group represented by $R^1$, examples of the saturated hydrocarbon group include a straight chain or branched chain alkyl group having 1 to 6 carbon atoms (such as a methyl group, an ethyl group, a propyl group, an isopropyl group, a butyl group, an isobutyl group, a pentyl group, and a hexyl group) and a cycloalkyl group having 3 to 6 carbon atoms (such as a cyclopentyl group and a cyclohexyl group).

In the above-described general formula (1), in the monovalent hydrocarbon group represented by $R^1$, an example of the aromatic hydrocarbon group includes an aryl group having 6 to 10 carbon atoms (such as a phenyl group and a naphthyl group).

In the above-described general formula (1), $R^1$s may be the same or different from each other. Preferably, $R^1$s are the same.

As the monovalent hydrocarbon group, preferably, an alkyl group having 1 to 6 carbon atoms and an aryl group having 6 to 10 carbon atoms are used, more preferably, in view of transparency, thermal stability, and light resistance, a methyl group and a phenyl group are used, or further more preferably, a methyl group is used.

In the above-described general formula (1), "n" is preferably, in view of stability and/or handling ability, an integer of 1 to 10,000, or more preferably an integer of 1 to 1,000.

"n" in the above-described general formula (1) is calculated as an average value.

To be specific, examples of the polysiloxane containing silanol groups at both ends include a polydimethylsiloxane containing silanol groups at both ends, a polymethylphenylsiloxane containing silanol groups at both ends, and a polydiphenylsiloxane containing silanol groups at both ends.

These polysiloxanes containing silanol groups at both ends can be used alone or in combination.

Of the polysiloxanes containing silanol groups at both ends, preferably, a polydimethylsiloxane containing silanol groups at both ends is used.

A commercially available product can be used as the polysiloxane containing silanol groups at both ends. A polysiloxane containing silanol groups at both ends synthesized in accordance with a known method can be also used.

The number average molecular weight of the polysiloxane containing silanol groups at both ends is, for example, in view of stability and/or handling ability, 100 to 1,000,000, or preferably 200 to 100,000. The number average molecular weight is calculated by conversion based on standard polystyrene with a gel permeation chromatography. The number average molecular weight of a material, other than the polysiloxane containing silanol groups at both ends, to be described later, is also calculated in the same manner as the description above.

The silanol group equivalent in the polysiloxane containing silanol groups at both ends is, for example, 0.002 to 25 mmol/g, or preferably 0.02 to 25 mmol/g.

The mixing ratio of the polysiloxane containing silanol groups at both ends with respect to 100 parts by mass of the condensation material is, for example, 1 to 99.99 parts by mass, preferably 50 to 99.9 parts by mass, or more preferably 80 to 99.5 parts by mass.

The ethylenic silicon compound is a silane compound having both an ethylenically unsaturated hydrocarbon group and a leaving group in the silanol condensation reaction and to be specific, is represented by the following general formula (2).

General Formula (2):

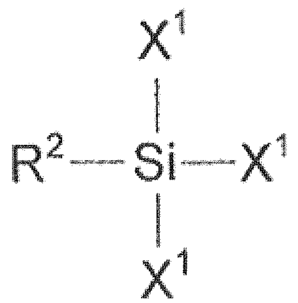

(2)

(where, in general formula (2), $R^2$ represents a monovalent ethylenically unsaturated hydrocarbon group. $X^1$ represents a halogen atom, an alkoxy group, a phenoxy group, or an acetoxy group. $X^1$s may be the same or different from each other.)

In the above-described general formula (2), examples of the ethylenically unsaturated hydrocarbon group represented by $R^2$ include a substituted or unsubstituted ethylenically unsaturated hydrocarbon group. Examples thereof include an alkenyl group and a cycloalkenyl group.

An example of the alkenyl group includes an alkenyl group having 2 to 10 carbon atoms such as a vinyl group, an allyl group, a propenyl group, a butenyl group, a pentenyl group, a hexenyl group, a heptenyl group, and an octenyl group.

An example of the cycloalkenyl group includes a cycloalkenyl group having 3 to 10 carbon atoms such as a cyclohexenyl group and a norbornenyl group.

As the ethylenically unsaturated hydrocarbon group, in view of reactivity with a hydrosilyl group, preferably, an alkenyl group is used, more preferably, an alkenyl group having 2 to 5 carbon atoms is used, or particularly preferably, a vinyl group is used.

$X^1$ in the above-described general formula (2) is a leaving group in the silanol condensation reaction. $SiX^1$ group in the above-described general formula (2) is a reactive functional group in the silanol condensation reaction.

In the above-described general formula (2), examples of the halogen atom represented by $X^1$ include a bromine atom, a chlorine atom, a fluorine atom, and an iodine atom.

In the above-described general formula (2), examples of the alkoxy group represented by $X^1$ include an alkoxy group containing a straight chain or branched chain alkyl group having 1 to 6 carbon atoms (such as a methoxy group, an ethoxy group, a propoxy group, an isopropoxy group, a butoxy group, an isobutoxy group, a pentyloxy group, and a hexyloxy group) and an alkoxy group containing a cycloalkyl group having 3 to 6 carbon atoms (such as a cyclopentyloxy group and a cyclohexyloxy group).

In the above-described general formula (2), $X^1$s may be the same or different from each other. Preferably, $X^1$s are the same.

Of the $X^1$s in the above-described general formula (2), preferably, an alkoxy group is used, or more preferably, a methoxy group is used.

Examples of the ethylenic silicon compound include a trialkoxysilane containing an ethylenically unsaturated hydrocarbon group, a trihalogenated silane containing an ethylenically unsaturated hydrocarbon group, a triphenoxysilane containing an ethylenically unsaturated hydrocarbon group, and a triacetoxysilane containing an ethylenically unsaturated hydrocarbon group.

These ethylenic silicon compounds can be used alone or in combination.

Of the ethylenic silicon compounds, preferably, a trialkoxysilane containing an ethylenically unsaturated hydrocarbon group is used.

To be specific, examples of the trialkoxysilane containing an ethylenically unsaturated hydrocarbon group include a vinyltrialkoxysilane such as a vinyltrimethoxysilane, a vinyltriethoxysilane, and a vinyltripropoxysilane; an allyltrimethoxysilane; a propenyltrimethoxysilane; a butenyltrimethoxysilane; and a cyclohexenyltrimethoxysilane.

Of the trialkoxysilanes containing an ethylenically unsaturated hydrocarbon group, preferably, a vinyltrialkoxysilane is used, or more preferably, a vinyltrimethoxysilane is used.

The mixing ratio of the ethylenic silicon compound with respect to 100 parts by mass of the condensation material is, for example, 0.01 to 90 parts by mass, preferably 0.01 to 50 parts by mass, or more preferably 0.01 to 10 parts by mass.

A commercially available product can be used as the ethylenic silicon compound. An ethylenic silicon compound synthesized in accordance with a known method can be also used.

The epoxy group-containing silicon compound is a silane compound having both an epoxy group and a leaving group in the silanol condensation reaction and to be specific, is represented by the following general formula (3).

General Formula (3):

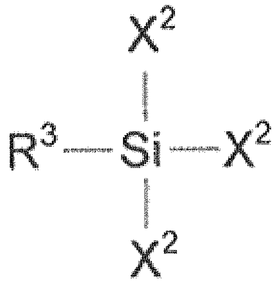

(3)

(where, in general formula (3), $R^3$ represents a group having an epoxy structure. $X^2$ represents a halogen atom, an alkoxy group, a phenoxy group, or an acetoxy group. $X^2$s may be the same or different from each other.)

In the above-described general formula (3), examples of the group having an epoxy structure represented by $R^3$ include an epoxy group, a glycidyl ether group, and an epoxycycloalkyl group such as an epoxycyclohexyl group.

Of the groups having an epoxy structure, preferably, a glycidyl ether group is used. To be specific, the glycidyl ether group is a glycidoxyalkyl group represented by the following general formula (4).

General Formula (4):

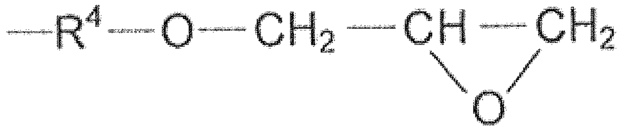

(4)

(where, in general formula (4), $R^4$ represents a divalent hydrocarbon group selected from a saturated hydrocarbon group and an aromatic hydrocarbon group.)

In the above-described general formula (4), in the divalent hydrocarbon group represented by $R^4$, examples of the saturated hydrocarbon group include an alkylene group having 1 to 6 carbon atoms (such as a methylene group, an ethylene group, a propylene group, and a butylene group) and a cycloalkylene group having 3 to 8 carbon atoms (such as a cyclopentylene group and a cyclohexylene group).

In the above-described general formula (4), in the divalent hydrocarbon group represented by $R^4$, an example of the aromatic hydrocarbon group includes an arylene group having 6 to 10 carbon atoms (such as a phenylene group and a naphthylene group).

As the divalent hydrocarbon group, preferably, an alkylene group having 1 to 6 carbon atoms is used, or more preferably, a propylene group is used.

To be specific, examples of the glycidyl ether group include a glycidoxymethyl group, a glycidoxyethyl group, a glycidoxypropyl group, a glycidoxycyclohexyl group, and a glycidoxyphenyl group.

Of the glycidyl ether groups, preferably, a glycidoxypropyl group is used.

$X^2$ in the above-described general formula (3) is a leaving group in the silanol condensation reaction. $SiX^2$ group in the above-described general formula (3) is a reactive functional group in the silanol condensation reaction.

In the above-described general formula (3), an example of the halogen atom represented by $X^2$ includes the same halogen atom as that represented by $X^1$ in the above-described general formula (2).

In the above-described general formula (3), an example of the alkoxy group represented by $X^2$ includes the same alkoxy group as that represented by $X^1$ in the above-described general formula (2).

In the above-described general formula (3), $X^2$s may be the same or different from each other. Preferably, $X^2$s are the same.

As $X^2$ in the above-described general formula (3), preferably, an alkoxy group is used, or more preferably, a methoxy group is used.

Examples of the epoxy group-containing silicon compound include an epoxy group-containing trialkoxysilane, an epoxy group-containing trihalogenated silane, an epoxy group-containing triphenoxysilane, and an epoxy group-containing triacetoxysilane.

These epoxy group-containing silicon compounds can be used alone or in combination.

Of the epoxy group-containing silicon compounds, preferably, an epoxy group-containing trialkoxysilane is used.

To be specific, examples of the epoxy group-containing trialkoxysilane include a glycidoxyalkyltrimethoxysilane such as a glycidoxymethyltrimethoxysilane, a (2-glycidoxyethyl)trimethoxysilane, and a (3-glycidoxypropyl)trimethoxysilane; a (3-glycidoxypropyl)triethoxysilane; a (3-glycidoxypropyl)tripropoxysilane; and a (3-glycidoxypropyl)triisopropoxysilane.

Of the epoxy group-containing trialkoxysilanes, preferably, a glycidoxyalkyltrimethoxysilane is used, or more preferably, a (3-glycidoxypropyl)trimethoxysilane is used.

The mixing ratio of the epoxy group-containing silicon compound with respect to 100 parts by mass of the condensation material is, for example, 0.01 to 90 parts by mass, preferably 0.01 to 50 parts by mass, or more preferably 0.01 to 1 parts by mass.

A commercially available product can be used as the epoxy group-containing silicon compound. An epoxy group-containing silicon compound synthesized in accordance with a known method can be also used.

The molar ratio ($SiOH/(SiX^1 + SiX^2)$) of the silanol group (the SiOH group) in the polysiloxane containing silanol groups at both ends to the reactive functional group (the $SiX^1$ group and the $SiX^2$ group) in the ethylenic silicon compound and the epoxy group-containing silicon compound is, for example, 20/1 to 0.2/1, preferably 10/1 to 0.5/1, or more preferably substantially 1/1.

When the molar ratio exceeds the above-described range, there may be a case where a product in a semi-cured state (a semi-cured product) having an appropriate toughness cannot be obtained when the condensation/addition reaction curable type silicone resin composition is brought into a semi-cured state. On the other hand, when the molar ratio is below the above-described range, there may be a case where the mixing proportion of the ethylenic silicon compound and the epoxy group-containing silicon compound is excessively large, so that the heat resistance of the encapsulating resin layer 2 to be obtained is reduced.

When the molar ratio is within the above-described range (preferably, substantially 1/1), the silanol group (the SiOH group) in the polysiloxane containing silanol groups at both ends, and the reactive functional group (the $SiX^1$ group) in the ethylenic silicon compound and the reactive functional group (the $SiX^2$ group) in the epoxy group-containing silicon compound can be subjected to the condensation reaction neither too much nor too little.

The molar ratio of the ethylenic silicon compound to the epoxy group-containing silicon compound is, for example, 10/90 to 99/1, preferably 50/50 to 97/3, or more preferably 80/20 to 95/5.

When the molar ratio is within the above-described range, there is an advantage that the adhesiveness of a cured product can be improved, while the strength thereof is ensured.

The organohydrogensiloxane is an organopolysiloxane having, in one molecule, at least two hydrosilyl groups without containing an ethylenically unsaturated hydrocarbon group.

To be specific, an example of the organohydrogensiloxane includes an organopolysiloxane containing hydrogen atoms in its side chain and an organopolysiloxane containing hydrogen atoms at both ends.

The organopolysiloxane containing hydrogen atoms in its side chain is an organohydrogensiloxane having hydrogen atoms as a side chain that branches off from the main chain. Examples thereof include a methylhydrogenpolysiloxane, a dimethylpolysiloxane-co-methylhydrogenpolysiloxane, an ethylhydrogenpolysiloxane, and a methylhydrogenpolysiloxane-co-methylphenylpolysiloxane.

The number average molecular weight of the organopolysiloxane containing hydrogen atoms in its side chain is, for example, 100 to 1,000,000, or preferably 100 to 100,000.

The organopolysiloxane containing hydrogen atoms at both ends is an organohydrogensiloxane having hydrogen atoms at both ends of the main chain. Examples thereof include a polydimethylsiloxane containing hydrosilyl groups at both ends, a polymethylphenylsiloxane containing hydrosilyl groups at both ends, and a polydiphenylsiloxane containing hydrosilyl groups at both ends.

The number average molecular weight of the organopolysiloxane containing hydrogen atoms at both ends is, for example, in view of stability and/or handling ability, 100 to 1,000,000, or preferably 100 to 100,000.

These organohydrogensiloxanes can be used alone or in combination.

Of the organohydrogensiloxanes, preferably, an organopolysiloxane containing hydrogen atoms in its side chain is used, or more preferably, a dimethylpolysiloxane-co-methylhydrogenpolysiloxane is used.

The hydrosilyl group equivalent in the organohydrogensiloxane is, for example, 0.1 to 30 mmol/g, or preferably 1 to 20 mmol/g.

A commercially available product can be used as the organohydrogensiloxane. An organohydrogensiloxane synthesized in accordance with a known method can be also used.

The mixing ratio of the organohydrogensiloxane with respect to 100 parts by mass of the ethylenic silicon compound is, though depending on the molar ratio of the ethylenically unsaturated hydrocarbon group ($R^2$ in the above-described general formula (2)) in the ethylenic silicon compound to the hydrosilyl group (the SiH group) in the organohydrogensiloxane, for example, 10 to 10,000 parts by mass, or preferably 100 to 1,000 parts by mass.

The molar ratio ($R^2/SiH$) of the ethylenically unsaturated hydrocarbon group ($R^2$ in the above-described general formula (2)) in the ethylenic silicon compound to the hydrosilyl group (the SiH group) in the organohydrogensiloxane is, for example, 20/1 to 0.05/1, preferably 20/1 to 0.1/1, more preferably 10/1 to 0.1/1, particularly preferably 10/1 to 0.2/1, or most preferably 5/1 to 0.2/1. The molar ratio thereof can be also set to be, for example, less than 1/1 and not less than 0.05/1.

When the molar ratio exceeds 20/1, there may be a case where a semi-cured product having an appropriate toughness cannot be obtained when the condensation/addition reaction curable type silicone resin composition is brought into a semi-cured state. On the other hand, when the molar ratio is below 0.05/1, there may be a case where the mixing proportion of the organohydrogensiloxane is excessively large, so that the heat resistance and the toughness of the encapsulating resin layer 2 to be obtained is insufficient.

When the molar ratio is less than 1/1 and not less than 0.05/1, in allowing the condensation/addition reaction curable type silicone resin composition to be in a semi-cured state, the condensation/addition reaction curable type silicone resin composition can be quickly transferred into a semi-cured state, compared to the condensation/addition

reaction curable type silicone resin composition whose molar ratio is 20/1 to 1/1.

The above-described polysiloxane containing silanol groups at both ends, ethylenic silicon compound, epoxy group-containing silicon compound, and organohydrogensiloxane are blended with a catalyst to be stirred and mixed, so that the condensation/addition reaction curable type silicone resin composition is prepared.

Examples of the catalyst include a condensation catalyst and an addition catalyst (a hydrosilylation catalyst).

The condensation catalyst is not particularly limited as long as it is a substance capable of improving the reaction rate of the condensation reaction of the silanol group with the reactive functional group (the $SiX^1$ group in the above-described general formula (2) and the $SiX^2$ group in the above-described general formula (3)). Examples of the condensation catalyst include an acid such as hydrochloric acid, acetic acid, formic acid, and sulfuric acid; a base such as potassium hydroxide, sodium hydroxide, potassium carbonate, and tetramethylammonium hydroxide; and a metal such as aluminum, titanium, zinc, and tin.

These condensation catalysts can be used alone or in combination.

Of the condensation catalysts, in view of compatibility and thermal decomposition properties, preferably, a base is used, or more preferably, tetramethylammonium hydroxide is used.

The mixing ratio of the condensation catalyst with respect to 100 mol of the polysiloxane containing silanol groups at both ends is, for example, 0.1 to 50 mol, or preferably 0.5 to 5 mol.

The addition catalyst is not particularly limited as long as it is a substance capable of improving the reaction rate of the addition reaction, that is, the hydrosilylation reaction of the ethylenically unsaturated hydrocarbon group with the SiH. An example of the addition catalyst includes a metal catalyst such as a platinum catalyst including platinum black, platinum chloride, a chloroplatinic acid, a platinum olefin complex, a platinum carbonyl complex, and platinum acetyl acetate; a palladium catalyst; and a rhodium catalyst.

These addition catalysts can be used alone or in combination.

Of the addition catalysts, in view of compatibility, transparency, and catalyst activity, preferably, a platinum catalyst is used, or more preferably, a platinum carbonyl complex is used.

The mixing ratio of the addition catalyst with respect to 100 parts by mass of the organohydrogensiloxane is, as a number of parts by mass of the metal amount in the addition catalyst, for example, $1.0 \times 10^{-4}$ to 1.0 parts by mass, preferably $1.0 \times 10^{-4}$ to 0.5 parts by mass, or more preferably $1.0 \times 10^{-4}$ to 0.05 parts by mass.

As the above-described catalyst, a catalyst in a solid state can be used as it is. Alternatively, in view of handling ability, a catalyst dissolved or dispersed in a solvent can be also used as a solution or a dispersion liquid.

An example of the solvent includes an organic solvent such as an alcohol including methanol and ethanol; a silicon compound including siloxane; an aliphatic hydrocarbon including hexane; an aromatic hydrocarbon including toluene; and ether including tetrahydrofuran (THF). An example of the solvent also includes an aqueous solvent such as water.

As the solvent, when the catalyst is a condensation catalyst, preferably, an alcohol is used and when the catalyst is an addition catalyst, preferably, a silicon compound is used.

In order to prepare the condensation/addition reaction curable type silicone resin composition, for example, the above-described materials (the condensation materials and the addition materials) and the catalysts can be added simultaneously. Alternatively, each of the materials and each of the catalysts can be added, respectively, at different timings. Furthermore, a part of the components can be added simultaneously and each of the remaining components can be added, respectively, at different timings.

Of the preparing methods of the condensation/addition reaction curable type silicone resin composition, preferably, the following method is used. The condensation materials and the condensation catalyst are first added simultaneously. Next, the addition material is added thereto and then, the addition catalyst is added thereto.

To be specific, the polysiloxane containing silanol groups at both ends, the ethylenic silicon compound, and the epoxy group-containing silicon compound (that is, the condensation materials) are simultaneously blended with the condensation catalyst at the above-described proportion to be stirred for, for example, 5 minutes to 24 hours.

At the time of blending and stirring, the temperature can be also adjusted to be, for example, 0 to 60°C so as to improve the compatibility and the handling ability of the condensation materials.

Thereafter, the pressure in the system (the above-described mixture) is reduced as required, so that a volatile component (an organic solvent) is removed.

Next, the organohydrogensiloxane is blended into the obtained mixture of the condensation materials and the condensation catalyst to be stirred for, for example, 1 to 120 minutes.

At the time of blending and stirring, the temperature can be also adjusted to be, for example, 0 to 60°C so as to improve the compatibility and the handling ability of the mixture and the organohydrogensiloxane.

Thereafter, the addition catalyst is blended into the system (the above-described mixture) to be stirred for, for example, 1 to 60 minutes.

In this way, the condensation/addition reaction curable type silicone resin composition can be prepared.

The prepared condensation/addition reaction curable type silicone resin composition is, for example, in a liquid

state (in an oil state). As described later, after the condensation/addition reaction curable type silicone resin composition is applied onto the phosphor layer 4, the condensation materials are subjected to a condensation reaction by heating to be brought into a B-stage state (to be brought into a semi-cured state). Thereafter, as described later (ref: FIG. 3 (b)), after the light emitting diode element 7 is embedded by the encapsulating resin layer 2, the addition material is subjected to an addition reaction by heating to form a condensation/addition reaction curable type silicone resin to be then brought into a C-stage state (to be brought into a completely cured state). In this way, the light emitting diode element 7 is encapsulated.

The mixing ratio of the silicone resin in the encapsulating resin composition is, for example, 70 mass % or more, preferably 90 mass % or more, or more preferably substantially 100 mass %.

A filler and/or a phosphor (described later) can be also added to the encapsulating resin composition as required.

Examples of the filler include silica (silicon dioxide), barium sulfate, barium carbonate, barium titanate, titanium oxide, zirconium oxide, magnesium oxide, zinc oxide, iron oxide, aluminum hydroxide, calcium carbonate, layered mica, carbon black, diatomite, glass fiber, and silicone resin microparticles.

The average particle size (the average of the maximum length) of the filler is, for example, 0.2 to 40 μm, or preferably 0.5 to 10 μm. The average particle size is measured with a particle size distribution analyzer.

These fillers can be used alone or in combination.

Of the fillers, preferably, silica (silicon dioxide) and silicone resin microparticles are used in combination.

The silicone resin microparticles are microparticles of the polysiloxane (after curing) having a cross-linked structure. The refractive index thereof is similar to that of the silicone resin composition (the encapsulating resin layer 2 after curing). Examples of the silicone resin microparticles include polysilsesquioxane microparticles and in view of hardness (the reinforcing effect of the encapsulating resin layer 2 with respect to the barrier film layer 3), preferably, polymethylsilsesquioxane microparticles are used.

The addition ratio of the silica with respect to 100 parts by mass of the encapsulating resin composition is, for example, 1 to 50 parts by mass, or preferably 5 to 20 parts by mass. The addition ratio of the silicone resin microparticles with respect to 100 parts by mass of the encapsulating resin composition is, for example, 1 to 60 parts by mass, or preferably 10 to 50 parts by mass.

The addition ratio of the phosphor with respect to the encapsulating resin composition is, for example, 1 to 50 mass %, or preferably 10 to 40 mass %.

Furthermore, a known additive can be added to the above-described encapsulating resin composition at an appropriate proportion as required. Examples of the known additive include antioxidants, modifiers, surfactants, dyes, pigments, discoloration inhibitors, and ultraviolet absorbers.

The encapsulating resin composition is subjected to a defoaming process as required after the preparation thereof.

An example of a defoaming method includes a known defoaming method such as reduced pressure defoaming (vacuum defoaming), centrifugal defoaming, and ultrasonic defoaming. Preferably, reduced pressure defoaming (vacuum defoaming) is used.

When the defoaming method is the reduced pressure defoaming (vacuum defoaming), the defoaming conditions are as follows: a temperature of, for example, 10 to 40°C, or preferably 15 to 35°C and a duration of, for example, 10 minutes or more, or preferably 30 minutes or more.

When the encapsulating resin layer 2 is formed of an encapsulating resin composition containing a thermosetting resin (preferably, a silicone resin), preferably, the encapsulating resin layer 2 is formed of an encapsulating resin composition in a semi-cured (in a B-stage) state.

The thickness of the encapsulating resin layer 2 is not particularly limited and is appropriately adjusted so that the light emitting diode element 7 can be embedded at the time of encapsulating the light emitting diode element 7 to be described later (ref: FIG. 3 (b)). To be specific, the thickness of the encapsulating resin layer 2 is, for example, 300 to 3,000 μm, or preferably 500 to 2,000 μm.

The encapsulating resin layer 2 may be formed of a single layer or a plurality of layers.

The barrier film layer 3 is formed into a film (a sheet or a tape) shape. The barrier film layer 3 is provided at the uppermost side in the encapsulating sheet 1.

The barrier film layer 3 is not particularly limited as long as it is a barrier film which is capable of preventing a material (to be specific, an unreacted liquid material, that is, a monomer) in the encapsulating resin layer 2 from infiltrating in the thickness direction of the encapsulating sheet 1 to passing therethrough and is capable of preventing the above-described material from precipitating toward the upper side of the encapsulating sheet 1.

Examples of the barrier film include an organic high molecular weight film and a metal film. Preferably, in view of transparency, an organic high molecular weight film is used.

The organic high molecular weight film is formed from a resin such as a thermoplastic resin and a thermosetting resin into a film shape.

Examples of the thermoplastic resin include a polyester resin (ester of diol and a dicarboxylic acid) such as

polyethylene terephthalate (PET) and polyethylene naphthalate (PEN); a polycarbonate resin; a polyimide resin such as polyamide imide, polyamino bismaleimide, polyimide, and polyether imide; a polysulfone resin such as polysulfone and polyether sulfone; and a fluorine resin such as an ethylene-tetrafluoroethylene copolymer (ETFE), polytetrafluoroethylene (PTFE), perfluoro alkoxyalkan (PFA, to be specific, a tetrafluoroethylene-perfluoroalkyl vinyl ether copolymer resin), a perfluoroethylene-propene copolymer (FEP), polyvinylidene fluoride (PVDF), and an ethylene-chlorotrifluoroethylene copolymer (ECTFE).

An example of the thermosetting resin includes the same thermosetting resin as that illustrated in the encapsulating resin layer 2.

As the resin, preferably, a thermoplastic resin is used, or more preferably, a polyester resin (or further more preferably, polyethylene terephthalate), a polycarbonate resin, and a fluorine resin are used.

The glass transition temperature of the organic high molecular weight film is, for example, the room temperature or more and the organic high molecular weight film is formed as a hard film.

The metal film is formed of, for example, a metal such as copper, silver, gold, iron, aluminum, or stainless steel into a film shape (a foil shape).

A commercially available product can be used as the barrier film.

The total light absorption coefficient in the thickness direction of the barrier film layer 3 with respect to light at the wavelength of 450 nm is, for example, 8 % or less, preferably 5 % or less, or more preferably 2 % or less, and is, for example, above 0 %.

When the total light absorption coefficient of the barrier film layer 3 is above the above-described upper limit, the luminous efficiency of a light emitting diode device 8 may be reduced.

The total light absorption coefficient of the barrier film layer 3 with respect to light at the wavelength of 450 nm is obtained by the following calculation formula (5).

Calculation Formula (5):

$$\text{The total light absorption coefficient} = 100\ \% - (\text{the total light transmittance} + 2 \times \text{the Fresnel reflection coefficient of the front surface}) \qquad (5)$$

The total light transmittance: the total light transmittance (%) in the thickness direction at the wavelength of 450 nm obtained in conformity with JIS K7361-1:1997

The Fresnel reflection coefficient of the front surface: the reflection coefficient at the interface between the surface of the barrier film layer 3 and the air obtained by the following calculation formula (6)

Calculation Formula (6):

$$\text{The Fresnel reflection coefficient of the front surface} = (1 - n)^2 / (1 + n)^2 \times 100 \qquad (6)$$

(where, in formula, "n" represents the refractive index of the barrier film layer 3)

The thickness of the barrier film layer 3 is, for example, 20 μm or more, or preferably 30 μm or more, and is, for example, 500 μm or less, preferably less than 200 μm, or more preferably less than 100 μm. When the thickness of the barrier film layer 3 is within the above-described range, the reduction of the material cost, the improvement of the optical properties, and the improvement of the handling ability can be achieved.

The phosphor layer 4 is formed to be adjacent to (in contact with) the lower surface of the barrier film layer 3. To be specific, the phosphor layer 4 is formed on the entire lower surface of the barrier film layer 3. The phosphor layer 4 is formed to be adjacent to (in contact with) the upper surface of the encapsulating resin layer 2. To be specific, the phosphor layer 4 is formed on the entire upper surface of the encapsulating resin layer 2.

The phosphor layer 4 is formed from a phosphor-containing resin composition into a generally sheet shape.

The phosphor-containing resin composition contains at least one phosphor and a resin composition.

The phosphor is particles having a wavelength conversion function. The phosphor is not particularly limited as long as it is a known phosphor used in the light emitting diode device 8 (ref. FIG. 3 (b)). An example of the phosphor includes a known phosphor such as a yellow phosphor which is capable of converting blue light into yellow light and a red phosphor which is capable of converting the blue light into red light.

Examples of the yellow phosphor include a garnet type phosphor having a garnet type crystal structure such

as $Y_3Al_5O_{12}$:Ce (YAG (yttrium aluminum garnet):Ce) and $Tb_3Al_3O_{12}$:Ce (TAG (terbium aluminum garnet):Ce) and an oxynitride phosphor such as Ca-$\alpha$-SiAlON.

An example of the red phosphor includes a nitride phosphor such as $CaAlSiN_3$:Eu and $CaSiN_2$:Eu.

Of the phosphors, preferably, a yellow phosphor is used, more preferably, Ca-$\alpha$-SiAlON and YAG:Ce are used, or particularly preferably, YAG:Ce is used.

These phosphors can be used alone or in combination.

The phosphor is in the form of a particle. The shape thereof is not particularly limited and examples of the shape thereof include a generally sphere shape, a generally flat plate shape, and a generally needle shape.

The average particle size (the average of the maximum length) of the phosphor is, for example, 0.1 to 500 $\mu$m, or preferably 0.2 to 200 $\mu$m. The average particle size of the phosphor particles is measured with a particle size distribution analyzer.

The degree of whitening is different in accordance with the type of the phosphor, the thickness of the phosphor layer 4, the shape of the encapsulating sheet 1, or the like, so that the mixing ratio of the phosphor is not particularly limited and is, for example, 1 to 50 mass %, or preferably 10 to 40 mass % with respect to the phosphor-containing resin composition.

The resin composition contains, for example, a known transparent resin used in encapsulating the light emitting diode element 7. An example of the transparent resin includes the same transparent resin as that described above.

These transparent resins can be used alone or in combination.

Of the transparent resins, preferably, a thermosetting resin is used, or more preferably, in view of durability, heat resistance, and light resistance, a silicone resin is used.

Of the resin compositions, preferably, a resin composition containing a silicone resin (a silicone resin composition) is used.

An example of the silicone resin composition includes the same silicone resin composition as that described above. Preferably, an addition reaction curable type silicone resin composition is used.

When the resin composition is the addition reaction curable type silicone resin composition, the cross-linking number of the siloxane skeleton can be appropriately adjusted by a known method such that the phosphor layer 4 has a low modulus enabling the phosphor layer 4 to maintain a constant thickness thereof even when subjected to the external force or a pressure at the time of the encapsulation.

A commercially available product (for example, LR-7665 manufactured by WACKER ASAHIKASEI SILICONE CO., LTD.) can be used as the addition reaction curable type silicone resin composition. An addition reaction curable type silicone resin composition synthesized in accordance with a known method can be also used.

The mixing ratio of the silicone resin in the resin composition is, for example, 70 mass % or more, preferably 90 mass % or more, or more preferably substantially 100 mass %.

The mixing ratio of the resin composition with respect to the phosphor-containing resin composition is, for example, 50 to 99 mass %, or preferably 60 to 90 mass %.

In order to prepare the phosphor-containing resin composition, the above-described phosphor and resin composition (preferably, the addition reaction curable type silicone resin composition) are blended to be stirred and mixed.

To be specific, when the resin composition is the addition reaction curable type silicone resin composition, the phosphor is blended into a liquid mixture obtained by mixing a main agent (A liquid) and a cross-linking agent (B liquid) to be stirred and mixed.

The liquid mixture in which the phosphor is blended is applied to the barrier film layer 3 (ref: FIG. 2 (b) or a release film to be described later) to be then heated and dried, so that the main agent (A liquid) and the cross-linking agent (B liquid) are subjected to the addition reaction to form a silicone elastomer which contains a phosphor.

A known additive can be added to the phosphor-containing resin composition at an appropriate proportion as required. Examples of the known additive include fillers (inorganic particles), curing agents, curing accelerators, antioxidants, modifiers, surfactants, dyes, pigments, discoloration inhibitors, and ultraviolet absorbers.

The phosphor-containing resin composition is subjected to a defoaming process as required after the preparation thereof.

An example of the defoaming method includes the above-described known defoaming method. Preferably, reduced pressure defoaming (vacuum defoaming) is used.

The thickness of the phosphor layer 4 is, for example, 20 to 300 $\mu$m, in view of whitening, preferably 30 to 200 $\mu$m, or more preferably 70 to 120 $\mu$m.

The thickness of the encapsulating sheet 1 is, for example, 20 to 5000 $\mu$m, or preferably 30 to 1500 $\mu$m.

As shown by a phantom line in FIG. 1, a separator 5 can be provided below the encapsulating resin layer 2 in the encapsulating sheet 1.

The separator 5 is a release layer which protects the lower surface of the encapsulating resin layer 2 before the encapsulation of the light emitting diode element 7 and is peeled from the encapsulating resin layer 2 at the time of the encapsulation of the light emitting diode element 7. The separator 5 is formed of, for example, the above-described

organic high molecular weight film.

A known release treatment can be also applied to the surface (at least, the upper surface) of the separator 5.

The thickness of the separator 5 is, in view of handling ability of the encapsulating sheet 1 and production cost of the encapsulating sheet 1, for example, 20 to 100 μm, or preferably 30 to 50 μm.

Next, a method for producing the encapsulating sheet 1 is described with reference to FIG. 2.

In this method, first, as shown in FIG. 2 (a), the barrier film layer 3 is prepared. The barrier film layer 3 is trimmed into, for example, a generally rectangular shape in plane view to be prepared.

Next, as shown in FIG. 2 (b), the phosphor layer 4 is formed on the barrier film layer 3.

Examples of a method for forming the phosphor layer 4 on the barrier film layer 3 include a method in which the phosphor layer 4 is directly formed on the barrier film layer 3 and a method in which after forming the phosphor layer 4 on another release film or the like, the formed phosphor layer 4 is transferred from the release film to the barrier film layer 3 by a laminator, a thermal compression bonding, or the like.

Preferably, the phosphor layer 4 is directly formed on the barrier film layer 3.

To be specific, first, the phosphor-containing resin composition is applied to the upper surface of the barrier film layer 3 to have the above-described thickness by a known application method such as a casting, a spin coating, and a roll coating. In this way, the phosphor layer 4 is directly formed on the barrier film layer 3.

When the phosphor-containing resin composition contains the thermosetting resin, the phosphor layer 4 is heated and dried, so that the phosphor layer 4 is brought into a B-stage state (a semi-cured state) or the phosphor layer 4 is brought into a C-stage state (a completely cured state) via the B-stage state.

The heating conditions are as follows: a heating temperature of, for example, 80 to 150°C, or preferably 90 to 150°C and a heating duration of, for example, 1 to 100 minutes, or preferably 5 to 15 minutes. Whether the phosphor layer 4 is brought into a B-stage state or a C-stage state can be appropriately set in accordance with the type of the thermosetting resin.

Next, as shown in FIG. 2 (c), the encapsulating resin layer 2 is formed on the phosphor layer 4.

Examples of a method for forming the encapsulating resin layer 2 on the phosphor layer 4 include a method in which the encapsulating resin layer 2 is directly formed on the phosphor layer 4 and a method in which after forming the encapsulating resin layer 2 on another release film or the like, the formed encapsulating resin layer 2 is transferred from the release film to the phosphor layer 4 by a laminator, a thermal compression bonding, or the like.

Preferably, the encapsulating resin layer 2 is directly formed on the phosphor layer 4.

In order to form the encapsulating resin layer 2 directly on the phosphor layer 4, for example, the encapsulating resin composition is applied to the entire upper surface of the phosphor layer 4 by a known application method such as a casting, a spin coating, and a roll coating.

In this way, the encapsulating resin layer 2 is formed on the phosphor layer 4.

When the encapsulating resin composition contains the thermosetting resin, the encapsulating resin layer 2 is heated, so that the encapsulating resin layer 2 which is prepared from the encapsulating resin composition is brought into a B-stage state (a semi-cured state).

The heating conditions are as follows: a temperature of, for example, 50 to 150°C, or preferably 80 to 140°C and a heating duration of, for example, 1 to 100 minutes, or preferably 5 to 15 minutes.

In this way, the encapsulating sheet 1 including the barrier film layer 3, the phosphor layer 4 which is laminated thereon, and the encapsulating resin layer 2 which is laminated thereon is obtained.

As shown in FIG. 2 (c), the separator 5 can be laminated on the encapsulating resin layer 2 as required.

The above-described encapsulating sheet 1 is formed into a generally rectangular shape in plane view. However, the shape thereof in plane view is not particularly limited to this and can be appropriately changed in accordance with its necessity. To be specific, the encapsulating sheet 1 can be also formed into, for example, a generally circular shape in plane view or the like.

Next, a method for producing the light emitting diode device 8 by encapsulating the light emitting diode element 7 using the above-described encapsulating sheet 1 is described with reference to FIG. 3.

First, as shown in FIG. 3 (a), a board 6 on which the light emitting diode element 7 is mounted is prepared.

The board 6 is formed into a generally flat plate shape. To be specific, the board 6 is formed of a laminated board in which a conductive layer (not shown) including an electrode pad (not shown) and a wire (not shown), as a circuit pattern, is laminated on an insulating board. The insulating board is formed of, for example, a silicon board, a ceramic board, a polyimide resin board, or the like. Preferably, the insulating board is formed of a ceramic board, to be specific, a sapphire board.

The conductive layer is formed of, for example, a conductor such as gold, copper, silver, or nickel. The thickness of the board 6 is, for example, 30 to 1500 μm, or preferably 50 to 1000 μm.

The light emitting diode element 7 is provided on the surface of the board 6 and is formed into a generally rectangular shape in sectional view. The light emitting diode element 7 is flip-chip mounting connected or wire bonding connected to the electrode pad in the board 6. In this way, the light emitting diode element 7 is electrically connected

the electrode pad. The light emitting diode element 7 is, for example, an element which emits blue light.

Next, as shown in FIG. 3 (a), the encapsulating sheet 1 is disposed in opposed relation to the top side of the board 6.

The size of the encapsulating sheet 1 is adjusted so as to be capable of embedding the light emitting diode element 7 to be encapsulated. The size of the encapsulating sheet 1 is formed to be larger by, for example, 1 to 20 mm, or preferably 2 to 10 mm than the outer circumference line of the projected surface in the up-down direction of the light emitting diode element 7. Although not shown, when a plurality of the light emitting diode elements 7 are collectively encapsulated, the size of the encapsulating sheet 1 is larger by, for example, 1 to 20 mm, or preferably 2 to 10 mm than the outer circumference line of the projected surface in the up-down direction of the light emitting diode element 7 which is located at the most outer side.

Next, as shown in FIG. 3 (b), the light emitting diode element 7 is embedded by the encapsulating resin layer 2 in the encapsulating sheet 1.

To be specific, the encapsulating sheet 1 is thermal compressively bonded to the board 6.

To be more specific, the encapsulating sheet 1 and the board 6 are flat plate pressed.

The pressing conditions are as follows: a temperature of, for example, 80 to 220°C, or preferably 100 to 200°C; a pressure of, for example, 0.01 to 1 MPa, or preferably 0.01 to 0.5 MPa; and a pressing duration of, for example, 1 to 10 minutes.

By the thermal compression bonding, the upper surface and the side surfaces of the light emitting diode element 7 are covered with the encapsulating resin layer 2. That is, the light emitting diode element 7 is embedded in the encapsulating resin layer 2.

The portion of the upper surface of the board 6 that is exposed from the light emitting diode element 7 is covered with the encapsulating resin layer 2.

That is, the encapsulating sheet 1 is allowed to adhere to the light emitting diode element 7 and the board 6.

By the thermal compression bonding, when the phosphor-containing resin composition contains the thermosetting resin and/or when the encapsulating resin composition contains the thermosetting resin, the phosphor layer 4 and/or the encapsulating resin layer 2 are/is brought into a C-stage state (completely cured). In a case where the phosphor layer 4 is already formed from the phosphor-containing resin composition into a C-stage state, when the encapsulating resin composition contains the thermosetting resin, the encapsulating resin layer 2 is brought into a C-stage state (completely cured) by the thermal compression bonding.

In this way, the light emitting diode device 8 in which the light emitting diode element 7 is encapsulated by the encapsulating resin layer 2 is obtained.

That is, the light emitting diode device 8 is provided with the board 6, the light emitting diode element 7 which is mounted on the board 6, and the encapsulating sheet 1 which is formed on the board 6 and encapsulates the light emitting diode element 7. The phosphor layer 4 is interposed between the encapsulating resin layer 2 and the barrier film layer 3, while the encapsulating resin layer 2 embeds the light emitting diode element 7 and the barrier film layer 3 is disposed at the uppermost side in the light emitting diode device 8.

Thereafter, as referred by the phantom lines in FIG. 2 (c), the separator 5 which is provided as required is peeled from the encapsulating resin layer 2.

In the encapsulating sheet 1, the barrier film layer 3 is formed at the upper side of the encapsulating resin layer 2.

Therefore, in the light emitting diode device 8 in which the light emitting diode element 7 is encapsulated by the encapsulating sheet 1, even when the light emitting diode element 7 and the encapsulating resin layer 2 generate heat along with the light emission, a bleeding in which a residual monomer (an unreacted liquid resin) in the encapsulating resin layer 2 precipitates toward the upper side of the light emitting diode device 8 can be suppressed by the barrier film layer 3.

As a result, it is possible to improve the appearance of the light emitting diode device 8.

In addition, the light emitting diode device 8 is reinforced by the barrier film layer 3, so that a deformation can be effectively prevented.

In the embodiment in FIG. 1, the encapsulating sheet 1 is formed into a generally rectangular shape in sectional view. Alternatively, for example, though not shown, the encapsulating sheet 1 can be also formed into a generally tapered shape (a shape in which the diameter is gradually reduced toward the upper side) in which the length in the plane direction is gradually reduced toward the upper side) or the like.

FIG. 4 shows process drawings for illustrating another embodiment of a method for producing a light emitting diode device of the present invention in which the light emitting diode device is produced by encapsulating a light emitting diode element by the encapsulating sheet in FIG. 1: FIG. 4 (a) illustrating a step of preparing an encapsulating sheet, a board, and a metal mold die and FIG. 4 (b) illustrating a step of pressure molding the encapsulating sheet using the metal mold die. FIG. 5 shows a sectional view of another embodiment (an embodiment in which an encapsulating sheet is formed of a barrier film layer and an encapsulating resin layer) of the encapsulating sheet of the present invention. FIG. 6 shows a sectional view of another embodiment (an embodiment in which a barrier film layer is interposed between

a phosphor layer and an encapsulating resin layer) of the encapsulating sheet of the present invention. FIG. 7 shows process drawings for illustrating a method for producing a light emitting diode device by encapsulating a light emitting diode element by the encapsulating sheet in FIG. 6: FIG. 7 (a) illustrating a step of preparing an encapsulating sheet and a board and FIG. 7 (b) illustrating a step of encapsulating the light emitting diode element using a flat plate press. FIG. 8 shows process drawings for illustrating a method for producing a light emitting diode device by encapsulating a light emitting diode element by the encapsulating sheet in FIG. 6: FIG. 8 (a) illustrating a step of preparing an encapsulating sheet, a board, and a metal mold die and FIG. 8 (b) illustrating a step of pressure molding the encapsulating sheet using the metal mold die.

In each figure to be described below, the same reference numerals are provided for members corresponding to each of those described above, and their detailed description is omitted.

In the embodiment in FIG. 3, the encapsulating sheet 1 is flat plate pressed. Alternatively, for example, as shown in FIG. 4, the encapsulating sheet 1 can be also pressure molded using a metal mold die 9.

In this method, as shown in FIG. 4 (a), the board 6, the encapsulating sheet 1 which is disposed in opposed relation to the upper side thereof, and the metal mold die 9 which is disposed in opposed relation to the upper side thereof are prepared, respectively.

The metal mold die 9 is formed into a generally rectangular shape in plane view. In the central portion of the lower side of the metal mold die 9, a concave portion 10 in a generally trapezoidal shape (a tapered shape) in sectional view in which the plane cross-sectional area is gradually reduced toward the upper side in sectional view is formed.

Next, as shown by arrows in FIG. 4 (a), the encapsulating sheet 1 is heated and pressurized toward the board 6 by the metal mold die 9.

The heating and pressurizing conditions are the same as those in the flat plate press described above.

In this way, as shown in FIG. 4 (b), the encapsulating sheet 1 is formed into a generally pentagonal shape in side view.

According to the embodiment in FIG. 4, the same function and effect as that of the embodiment in FIG. 3 can be achieved.

In the embodiment in FIG. 4, the concave portion 10 is formed into a generally trapezoidal shape (a tapered shape) in sectional view. However, the shape thereof is not particularly limited and though not shown, for example, the shape thereof can be also formed into an appropriate shape such as a generally semi-circular shape in sectional view (to be specific, a hemispherical lens shape).

In the embodiment in FIG. 1, the phosphor layer 4 is included in the encapsulating sheet 1. Alternatively, for example, as shown in FIG. 5, the encapsulating sheet 1 can be also obtained without including the phosphor layer 4.

In FIG. 5, the encapsulating sheet 1 includes the encapsulating resin layer 2 and the barrier film layer 3 which is laminated thereon.

In the encapsulating resin layer 2, a phosphor is, as an essential component, added to the encapsulating resin composition.

The barrier film layer 3 is formed on the entire upper surface of the encapsulating resin layer 2. That is, the barrier film layer 3 is directly formed on the upper surface of the encapsulating resin layer 2.

The thickness of the encapsulating sheet 1 is, for example, 20 to 5000 $\mu$m, or preferably 30 to 1500 $\mu$m.

In order to obtain the encapsulating sheet 1, for example, as referred in FIG. 2 (a), first, the barrier film layer 3 is prepared and next, as shown in FIG. 5, the encapsulating resin layer 2 is formed below the barrier film layer 3.

The encapsulating sheet 1 in FIG. 5 does not include the phosphor layer 4, so that the configuration thereof is simpler than that of the encapsulating sheet 1 in FIG. 1 in which the phosphor layer 4 is included and therefore, the encapsulating sheet 1 in FIG. 5 can be easily produced. Therefore, by the encapsulating sheet 1 in FIG. 5, the light emitting diode element 7 is easily encapsulated and the light emitting diode device 8 can be easily produced.

On the other hand, the encapsulating sheet 1 in FIG. 1 includes the phosphor layer 4, so that, as referred in FIG. 3 (b), the light emitting diode device 8 in which the light emitting diode element 7 is encapsulated by the encapsulating sheet 1 in FIG. 1 can emit high-energy white light by converting a part of blue light emitted from the light emitting diode element 7 into yellow light by the phosphor layer 4 to mix the blue light with the yellow light.

In addition, in the embodiment in FIG. 1, the phosphor layer 4 is provided below (at the other side in the thickness direction of) the barrier film layer 3. Alternatively, for example, as shown in the embodiment in FIG. 6, the phosphor layer 4 can be also provided on (at one side in the thickness direction of) the barrier film layer 3.

In FIG. 6, the phosphor layer 4 is provided at the uppermost side in the encapsulating sheet 1.

The barrier film layer 3 is interposed between the encapsulating resin layer 2 and the phosphor layer 4. To be specific, the barrier film layer 3 is formed on the entire upper surface of the encapsulating resin layer 2 and is formed on the entire lower surface of the phosphor layer 4.

As a method for obtaining the encapsulating sheet 1 shown in FIG. 6, for example, first, as shown in FIG. 2 (a), the barrier film layer 3 is prepared.

Thereafter, as shown in FIG. 6, the phosphor layer 4 is formed on the barrier film layer 3 and the encapsulating

resin layer 2 is formed below the barrier film layer 3.

As a method for forming the phosphor layer 4 and the encapsulating resin layer 2 on and below the barrier film layer 3, for example, an encapsulating resin composition and a phosphor-containing resin composition are simultaneously applied to the upper surface and the lower surface of the barrier film layer 3, respectively by a double-sided coater such as a roller, so that the encapsulating resin layer 2 and the phosphor layer 4 are formed. Subsequently, as shown by the phantom lines in FIG. 6, the separators 5 are laminated on the encapsulating resin layer 2 and on the phosphor layer 4.

Thereafter, when the encapsulating resin composition contains the thermosetting resin and/or when the phosphor-containing resin composition contains the thermosetting resin, the encapsulating resin layer 2 and/or the phosphor layer 4 are/is brought into a B-stage state by heating them/it. Preferably, when the encapsulating resin composition contains the thermosetting resin and when the phosphor-containing resin composition contains the thermosetting resin, the encapsulating resin layer 2 and the phosphor layer 4 are simultaneously brought into a B-stage state by simultaneously heating them.

Alternatively, for example, the phosphor layer 4 and the encapsulating resin layer 2 are formed on the surfaces of the separators 5 (ref: the phantom lines in FIG. 6), respectively. Thereafter, the phosphor layer 4 and the encapsulating resin layer 2 are simultaneously transferred to the upper surface and the lower surface of the barrier film layer 3, respectively, by a laminator, a thermal compression bonding, or the like. Then, the separators 5 are peeled from the phosphor layer 4 and the encapsulating resin layer 2 as required.

In addition, it is also possible that of the phosphor layer 4 and the encapsulating resin layer 2, one is formed by the application method and the other is formed by the transfer method.

In order to encapsulate the light emitting diode element 7 by the encapsulating sheet 1 in FIG. 6, first, as shown by the arrow in FIG. 6, the separator 5 which is provided as required is peeled from the encapsulating resin layer 2. On the other hand, as shown by the phantom line (the upper side) in FIG. 6, the separator 5 which is provided on the phosphor layer 4 is allowed to be left.

Then, as shown in FIG. 7 (a) (including the phantom lines), the encapsulating sheet 1 in which the separator 5 is laminated on the phosphor layer 4 is disposed in opposed relation to the upper side of the board 6 and subsequently, as shown in FIG. 7 (b), the encapsulating sheet 1 is allowed to adhere to the board 6 by a flat plate press.

Thereafter, as shown by the arrow (the upper side) in FIG. 7 (b), the separator 5 is peeled from the phosphor layer 4.

Alternatively, as shown in FIG. 8 (a) (including the phantom lines), the encapsulating sheet 1 in which the separator 5 is laminated on the phosphor layer 4 is disposed in opposed relation to the upper side of the board 6 and subsequently, as shown by the arrows in FIG. 8 (a), the encapsulating sheet 1 is pressure molded by the pressure molding using the metal mold die 9.

Thereafter, as shown by the arrow in FIG. 8 (b), the separator 5 is peeled from the phosphor layer 4. In this way, the light emitting diode device 8 is obtained.

On the other hand, in the encapsulation of the light emitting diode element 7 using the encapsulating sheet 1, first, the separator 5 which is laminated on the phosphor layer 4 is peeled from the phosphor layer 4 and thereafter, the encapsulating sheet 1 can be subjected to the encapsulation of the light emitting diode element 7.

In such a case, as shown by the arrow (the upper side) and a phantom line in FIG. 7 (a), first, the separator 5 is peeled from the upper surface of the phosphor layer 4. Subsequently, the encapsulating sheet 1 including the phosphor layer 4 from which the separator 5 is peeled is disposed in opposed relation to the upper side of the board 6. Next, as shown by the arrows (the lower side) in FIG. 7 (a), the encapsulating sheet 1 and the board 6 are flat plate pressed. In this way, as shown in FIG. 7 (b), the light emitting diode device 8 is obtained.

Alternatively, as shown by the phantom lines in FIG. 8 (a), the encapsulating sheet 1 including the phosphor layer 4 from which the separator 5 is peeled is disposed in opposed relation to the upper side of the board 6 and the metal mold die 9 is prepared above the encapsulating sheet 1. Subsequently, as shown by the arrows in FIG. 8 (a), the encapsulating sheet 1 is pressure molded using the metal mold die 9. In this way, as shown in FIG. 8 (b), the light emitting diode device 8 is obtained.

In the method for producing the encapsulating sheet 1 in FIG. 6, the encapsulating resin layer 2 and the phosphor layer 4 can be simultaneously formed on both surfaces of the upper surface and the lower surface of the barrier film layer 3 by a double-sided coater, a laminator, or the like, so that the production process thereof can be more simplified compared to that of the method for producing the encapsulating sheet 1 in FIG. 1.

On the other hand, the encapsulating sheets 1 in FIGS. 1 and 5, compared to the encapsulating sheet 1 in FIG. 6, have an advantage in terms of cost, production process, reliability, and environment.

In terms of cost, the same material as that used for the substrate can be used as a material for the barrier film layer 3, so that it is not necessary to consider the cost as a barrier film for exclusive use and additionally, unlike in the case of the separator, the process of peeling the barrier film layer 3 can be omitted in the subsequent step.

In terms of process, the barrier film layer 3 is provided at the uppermost side as a relatively hard layer, so that the handling ability in the operation is increased, leading to be advantageous.

In terms of reliability, the barrier film layer 3 is provided at the uppermost side as a relatively hard layer, so that a deformation of the light emitting diode device 8 is prevented and the durability thereof can be improved.

In terms of environment, a substrate or the like which has been conventionally abandoned as a separator can be reused, so that a burden to the environment can be reduced.

Among all, in the embodiment in FIG. 1, the barrier film layer 3 is disposed at the uppermost side in the encapsulating sheet 1. Therefore, as shown in FIGS. 3 (b) and 4 (b), the light emitting diode device 8 in which the light emitting diode element 7 is encapsulated by the encapsulating sheet 1 in FIG. 1 can more surely suppress a bleeding of a residual monomer in the phosphor layer 4, compared to the light emitting diode device 8 shown in FIGS. 7 (b) and 8 (b).

[Examples]

While the present invention will be described hereinafter in further detail with reference to Prepared Examples, Examples, and Comparative Examples, the present invention is not limited to these Prepared Examples, Examples, and Comparative Examples.

<Preparation of Phosphor-Containing Resin Composition>

Prepared Example 1

26 g of YAG:Ce (an average particle size of 8.9 μm) was mixed into 74 g of a liquid mixture (a mixing ratio (A/B) = 1/1) in which A liquid and B liquid of an addition reaction curable type silicone resin composition (LR7665, manufactured by WACKER ASAHIKASEI SILICONE CO., LTD.) were mixed to be stirred for 1 hour. After the stirring, the obtained mixture was subjected to a defoaming process under a reduced pressure with a vacuum dryer at room temperature for 30 minutes or more.

In this way, a phosphor-containing resin composition was prepared (a phosphor concentration of 26 mass %).

<Preparation of Encapsulating Resin Composition>

Prepared Example 2

15.76 g (0.106 mol) of a vinyltrimethoxysilane (an ethylenic silicon compound) and 2.80 g (0.0118 mol) of a (3-glycidoxypropyl)trimethoxysilane (an epoxy group-containing silicon compound) were blended into 2031 g (0.177 mol) of a polydimethylsiloxane containing silanol groups at both ends (a polysiloxane containing silanol groups at both ends, in general formula (1), all of $R^1$s are methyl groups, the average of "n" is 155, a number average molecular weight of 11,500, a silanol group equivalent of 0.174 mmol/g), which was heated at 40°C, and the obtained mixture was stirred and mixed.

The molar ratio (the number of moles of the SiOH group/the total number of moles of the $SiOCH_3$ group) of the SiOH group in the polydimethylsiloxane containing silanol groups at both ends to the $SiOCH_3$ group in the vinyltrimethoxysilane and the (3-glycidoxypropyl)trimethoxysilane was 1/1.

After the stirring and mixing, 0.97 mL (0.766 g, a catalyst content: 0.88 mmol, corresponding to 0.50 mol with respect to 100 mol of the polydimethylsiloxane containing silanol groups at both ends) of a methanol solution of tetramethylammonium hydroxide (a condensation catalyst, a concentration of 10 mass %) was added to the obtained mixture to be stirred at 40°C for 1 hour. The obtained mixture (an oil) was stirred under a reduced pressure (10 mmHg) at 40°C for 1 hour and a volatile component (methanol or the like) was removed.

Thereafter, the pressure in the system was brought back to the normal pressure and then, 44.5 g (0.022 mol) of an organohydrogensiloxane (manufactured by Shin-Etsu Chemical Co., Ltd., a dimethylpolysiloxane-co-methylhydrogenpolysiloxane, an average molecular weight of 2,000, a hydrosilyl group equivalent of 7.14 mmol/g) was added to the reacting product to be stirred at 40°C for 1 hour.

The molar ratio ($CH_2$=CH-/SiH) of the vinyl group ($CH_2$=CH-) in the vinyltrimethoxysilane to the hydrosilyl group (the SiH group) in the organohydrogensiloxane was 1/3.

Thereafter, 0.13 g (0.13 mL, a platinum content of 2 mass %, as a platinum, corresponding to $5.8 \times 10^{-3}$ parts by mass with respect to 100 parts by mass of the organohydrogensiloxane) of a siloxane solution of a platinum carbonyl complex (an addition catalyst, a platinum concentration of 2 mass %) was added to the system to be stirred at 40°C for 10 minutes, so that a mixture (an oil) was obtained.

Next, as fillers, 10 g of silica (trade name: FB-3SDC, manufactured by DENKI KAGAKU KOGYO KABUSHIKI KAISHA., an average particle size of 3.4 μm) and 30 g of silicone resin microparticles (manufactured by Momentive Performance Materials Inc., trade name: "Tospearl 2000B", an average particle size of 6.0 μm) were added to 60 g of the mixture (the oil) to be stirred at room temperature (at 20°C) for 10 minutes. After the stirring, the obtained mixture was subjected to a defoaming process under a reduced pressure with a vacuum dryer at room temperature for 30 minutes or more.

In this way, an encapsulating resin composition was prepared (a silica content of 10 mass %, a silicone resin microparticles content of 30 mass %).

(Production of Encapsulating Sheet and Production of Light Emitting Diode Device)

Example 1

First, as a barrier film, a polyethylene terephthalate film (manufactured by Mitsubishi Plastics, Inc., trade name: "T-100", a thickness of 50 μm) was prepared (ref: FIG. 2 (a)).

Next, the phosphor-containing resin composition in Prepared Example 1 was applied onto the polyethylene terephthalate film with a thickness of 100 μm to be dried at 100°C for 10 minutes, so that a phosphor layer in a C-stage state was formed (ref: FIG. 2 (b)).

Next, the encapsulating resin composition in Prepared Example 2 was applied onto the phosphor layer with a thickness of 1000 μm to be dried at 135°C for 10 minutes, so that an encapsulating resin layer in a B-stage state was formed (ref: FIG. 2 (c)).

In this way, the encapsulating sheet including the polyethylene terephthalate film, the phosphor layer, and the encapsulating resin layer was obtained.

Next, the encapsulating sheet was disposed with respect to a board mounted with a light emitting diode element such that the encapsulating resin layer was opposed to the light emitting diode element (ref: FIG. 3 (a)). Subsequently, the encapsulating sheet was thermal compressively bonded by a flat plate press under the pressing conditions of a temperature of 160°C, a duration of 5 minutes, and a pressure of 0.1 MPa, so that the light emitting diode element was encapsulated (ref: FIG. 3 (b)). The encapsulating resin layer was brought into a C-stage state by the thermal compression bonding.

In this way, a light emitting diode device in which the light emitting diode element was encapsulated by the encapsulating sheet was fabricated.

Example 2

An encapsulating sheet was obtained and subsequently, a light emitting diode device was fabricated in the same manner as in Example 1, except that as a barrier film, a polycarbonate film (manufactured by Kaneka Corporation, trade name: "TR", a thickness of 35 μm) was used instead of the polyethylene terephthalate film.

Example 3

An encapsulating sheet was obtained and subsequently, a light emitting diode device was fabricated in the same manner as in Example 1, except that as a barrier film, an ethylene-tetrafluoroethylene copolymer (ETFE) film (manufactured by ASAHI GLASS CO., LTD., trade name: "AFLEX", a thickness of 40 μm) was used instead of the polyethylene terephthalate film.

Example 4

An encapsulating sheet was obtained and subsequently, a light emitting diode device was fabricated in the same manner as in Example 1, except that as a barrier film, a polyethylene naphthalate film (manufactured by Teijin DuPont Films Japan Limited, trade name: "TeonexQ51", a thickness of 38 μm) was used instead of the polyethylene terephthalate film.

Comparative Example 1

First, as a separator, a polystyrene film (manufactured by Nippa CO., LTD., trade name: "SS4C", a thickness of 50 μm) was prepared (ref: FIG. 2 (a)).

Next, the phosphor-containing resin composition in Prepared Example 1 was applied onto the polystyrene film with a thickness of 100 μm to be dried at 100°C for 10 minutes, so that a phosphor layer in a B-stage state was formed (ref: FIG. 2 (b)).

Next, the encapsulating resin composition in Prepared Example 2 was applied onto the phosphor layer with a thickness of 1000 μm to be dried at 135°C for 10 minutes, so that an encapsulating resin layer in a B-stage state was formed (ref: FIG. 2 (c)).

Thereafter, the polystyrene film was peeled from the phosphor layer.

In this way, an encapsulating sheet including the phosphor layer and the encapsulating resin layer was obtained.

Next, the encapsulating sheet was disposed with respect to a board mounted with a light emitting diode element such that the encapsulating resin layer was opposed to the light emitting diode element. Subsequently, the encapsulating sheet was thermal compressively bonded by a flat plate press under the pressing conditions of a temperature of 160°C, a duration of 5 minutes, and a pressure of 0.1 MPa, so that the light emitting diode element was encapsulated. The encapsulating resin layer and the phosphor layer were brought into a C-stage state by the thermal compression bonding.

In this way, a light emitting diode device in which the light emitting diode element was encapsulated by the encapsulating sheet was fabricated.

(Evaluation)

1. Precipitation Test (Bleeding Test) and Shape Change Test of Liquid Resin

In each of the light emitting diode devices in Examples and Comparative Examples, an electric current of 100 mA was applied through the light emitting diode element, so that the light emitting diode element was allowed to continuously light up in a constant temperature and humidity chamber which was set to be at 85°C and a relative humidity (RH) of 85 % to be evaluated in accordance with the following description. The results are shown in Table 1.

<Precipitation of Liquid Resin>

The evaluation was conducted as follows: when a bleeding of the liquid resin was not confirmed on the surface of the light emitting diode device 1000 hours after the start of the continuous lighting up visually or with an optical microscope, the light emitting diode device was evaluated as "Good" and when a bleeding of the liquid resin was confirmed

thereon, the light emitting diode device was evaluated as "Bad".

<Deformation of Light Emitting Diode Device>

The evaluation was conducted as follows: when a deformation of the light emitting diode device was not confirmed 1000 hours after the start of the continuous lighting up visually or with an optical microscope, the light emitting diode device was evaluated as "Good" and when a deformation of the light emitting diode device was confirmed, the light emitting diode device was evaluated as "Bad".

<Change in Chromaticity on Surface of Light Emitting Diode Device>

The chromaticity of the light emitting diode device over a lapse of time at the lighting up test was evaluated from the total luminous flux with a multi-channel photo-detector (manufactured by Otsuka Electronics Co., Ltd., MCPD-9800). The evaluation was conducted as follows: a deviation of the CIE y value after 0 hour from the start of the continuous lighting up was calculated 1000 hours after its start and when the obtained value was less than 0.01, the light emitting diode device was evaluated as "Good"; when the obtained value was not less than 0.01 and less than 0.02, the light emitting diode device was evaluated as "Poor"; and when the obtained value was not less than 0.02, the light emitting diode device was evaluated as "Bad".

2. Total Light Absorption Coefficient (Barrier Film Layer)

The total light absorption coefficient of each of the barrier films in Examples at the wavelength of 450 nm was calculated.

The total light absorption coefficient was calculated based on the above-described calculation formulas (5) and (6) after first measuring the total light transmittance of each of the barrier films at the wavelength of 450 nm with an ultraviolet and visible spectrophotometer (manufactured by JASCO Corporation, V-60). The results are shown in Table 1.

In the calculation formula (6), the refractive index of each of the barrier films in Examples 1 to 4 was calculated as 1.65, 1.59, 1.42, and 1.50.

Table 1

| | Barrier Film Layer | | Total Light Absorption Coefficient (%) | Lighting Up Test (85°C, 85 %RH, 100 mA) | | |
|---|---|---|---|---|---|---|
| | Type | Thickness (μm) | | Precipitation of Liquid Resin | Deformation | Change in Chromaticity |
| Ex. 1 | Polyethylene Terephthalate | 50 | 1 | Good | Good | Good |
| Ex. 2 | Polycarbonate | 35 | 0 | Good | Good | Good |
| Ex. 3 | Ethylene-Tetrafluoroethylene Copolymer | 40 | 0 | Good | Good | Good |
| Ex. 4 | Polyethylene Naphthalate | 38 | 10 | Good | Good | Bad |
| Comp. Ex. 1 | (Polystyrene *1) | (50) | - | Bad | Bad | Poor |
| *1: As a separator, a peeling was performed later. | | | | | | |

While the illustrative embodiments of the present invention are provided in the above description, such is for illustrative purpose only and it is not to be construed as limiting the scope of the present invention. Modification and variation of the present invention that will be obvious to those skilled in the art is to be covered by the following claims.

## Claims

**1.** An encapsulating sheet comprising:

an encapsulating resin layer and
a barrier film layer formed at one side in a thickness direction of the encapsulating resin layer.

**2.** The encapsulating sheet according to claim 1, wherein

the total light absorption coefficient in the thickness direction of the barrier film layer with respect to light at the wavelength of 450 nm is 8 % or less.

**3.** The encapsulating sheet according to claim 1, wherein
the thickness of the barrier film layer is less than 200 μm.

**4.** The encapsulating sheet according to claim 1, wherein
the encapsulating sheet further includes a phosphor layer which is formed so as to be adjacent to the barrier film layer.

**5.** The encapsulating sheet according to claim 4, wherein
the barrier film layer is formed at one side in the thickness direction with respect to the phosphor layer.

**6.** A method for producing a light emitting diode device comprising a step of:

encapsulating a light emitting diode element by embedding the light emitting diode element which is mounted on a board by an encapsulating resin layer in an encapsulating sheet including the encapsulating resin layer and a barrier film layer formed at one side in a thickness direction of the encapsulating resin layer.

**7.** A light emitting diode device obtained by a method for producing a light emitting diode device including a step of encapsulating a light emitting diode element by embedding the light emitting diode element which is mounted on a board by an encapsulating resin layer in an encapsulating sheet including the encapsulating resin layer and a barrier film layer formed at one side in a thickness direction of the encapsulating resin layer.

FIG. 1

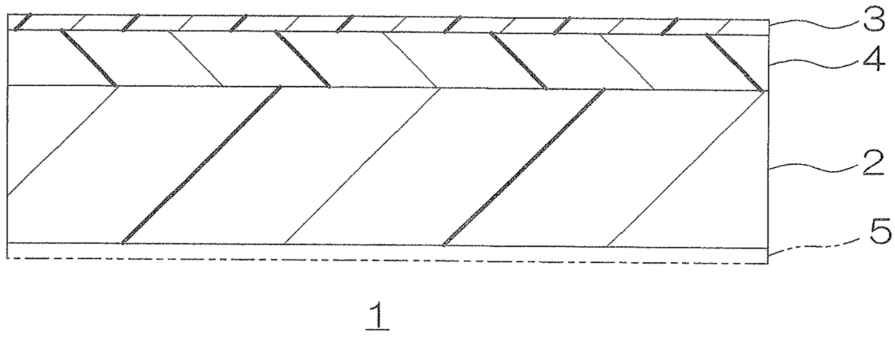


FIG.2

FIG.2 (a)

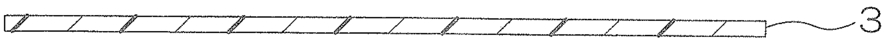


FIG.2 (b)

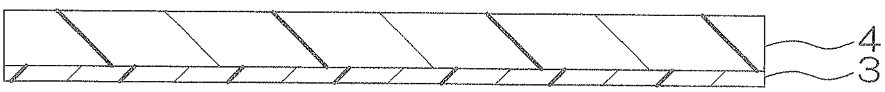


FIG.2 (c)

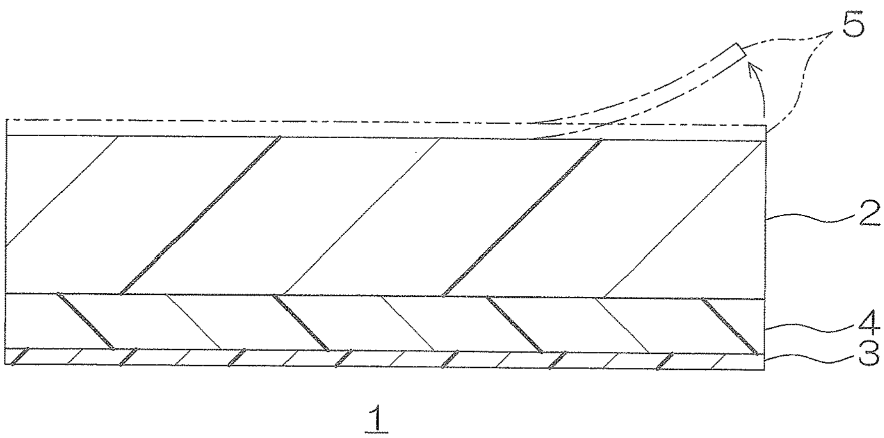

FIG. 3

FIG. 3 (a)

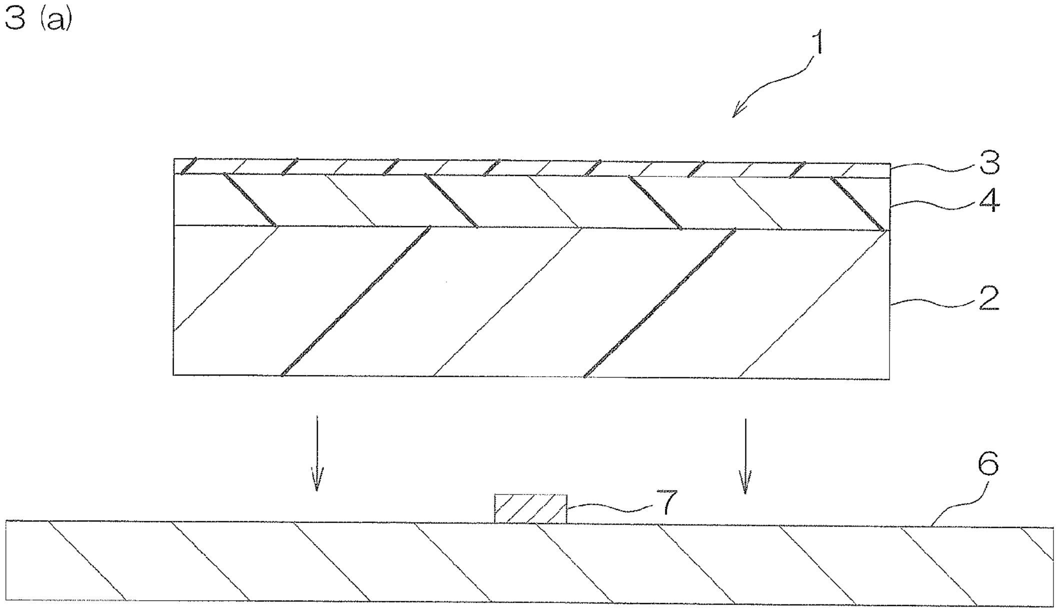


FIG. 3 (b)

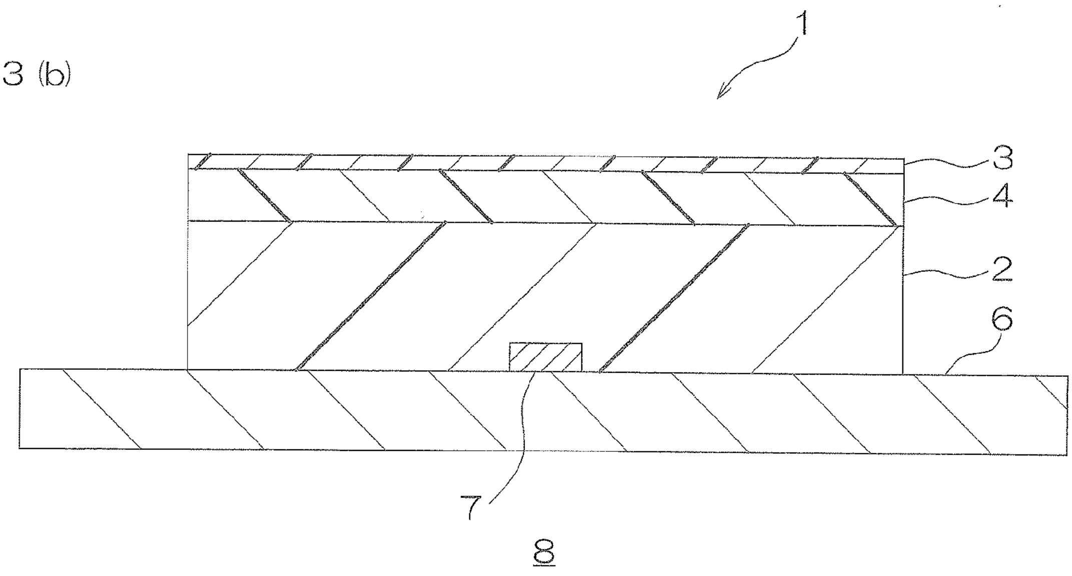

FIG. 4

FIG. 4 (a)

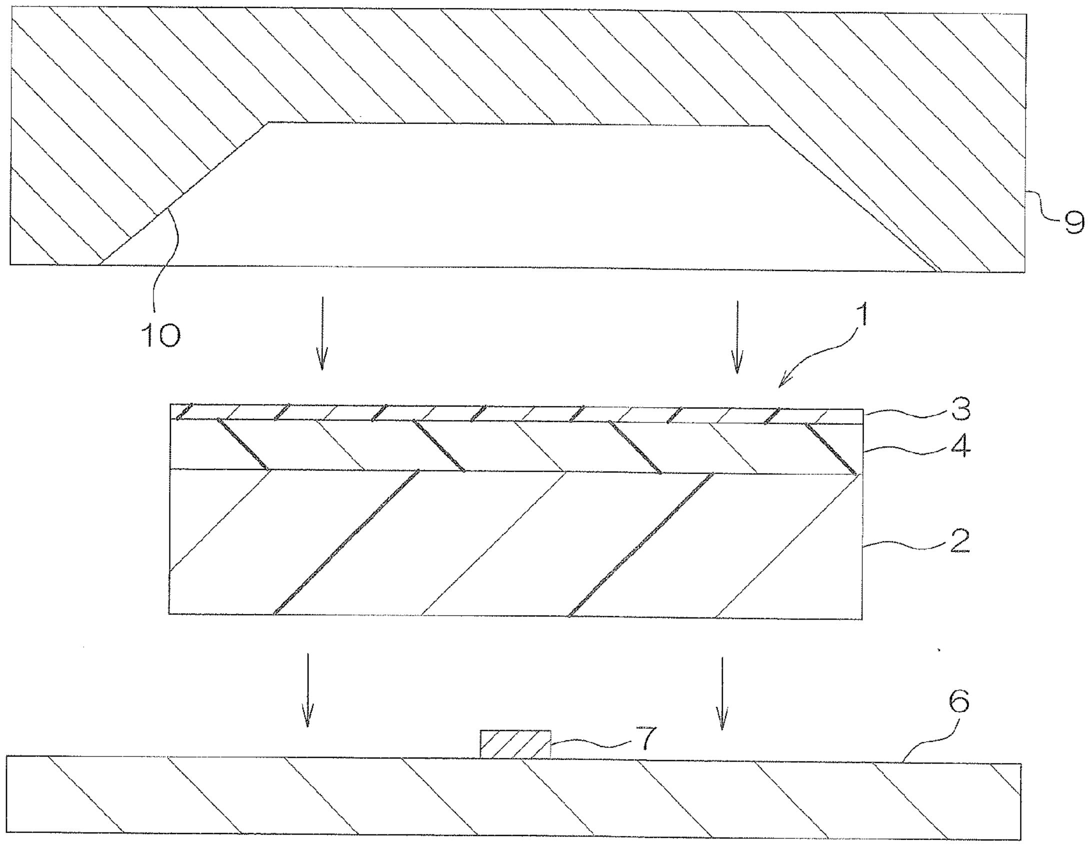


FIG. 4 (b)

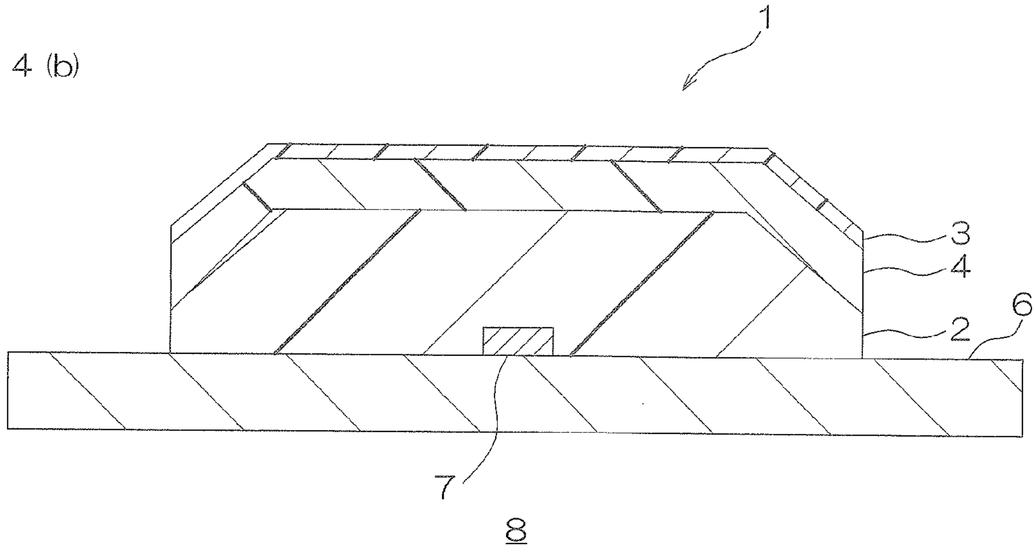

FIG. 5

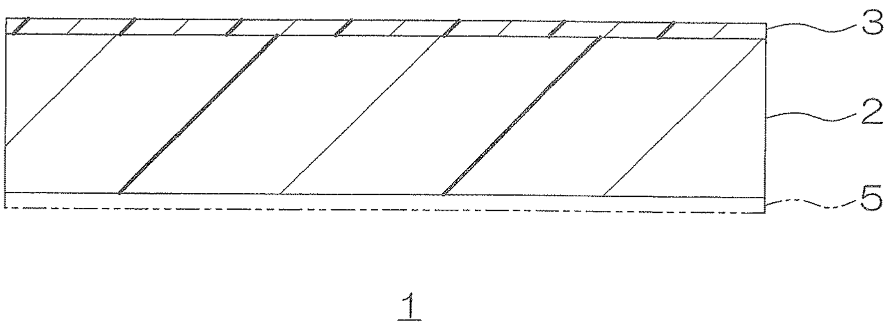


FIG. 6

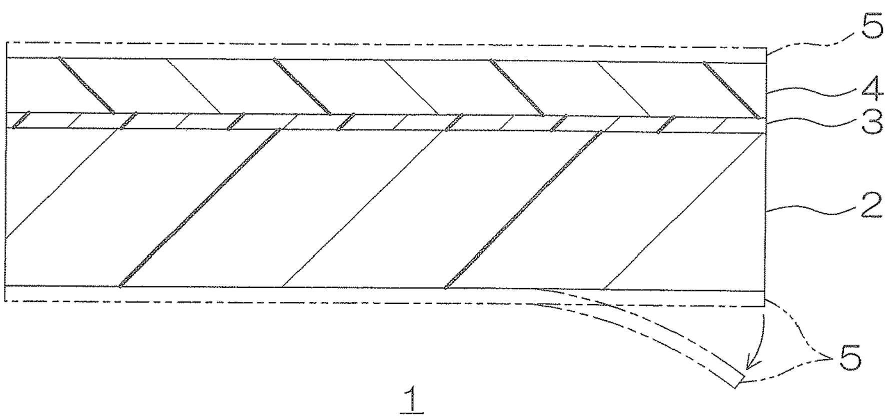

FIG. 7

FIG. 7 (a)

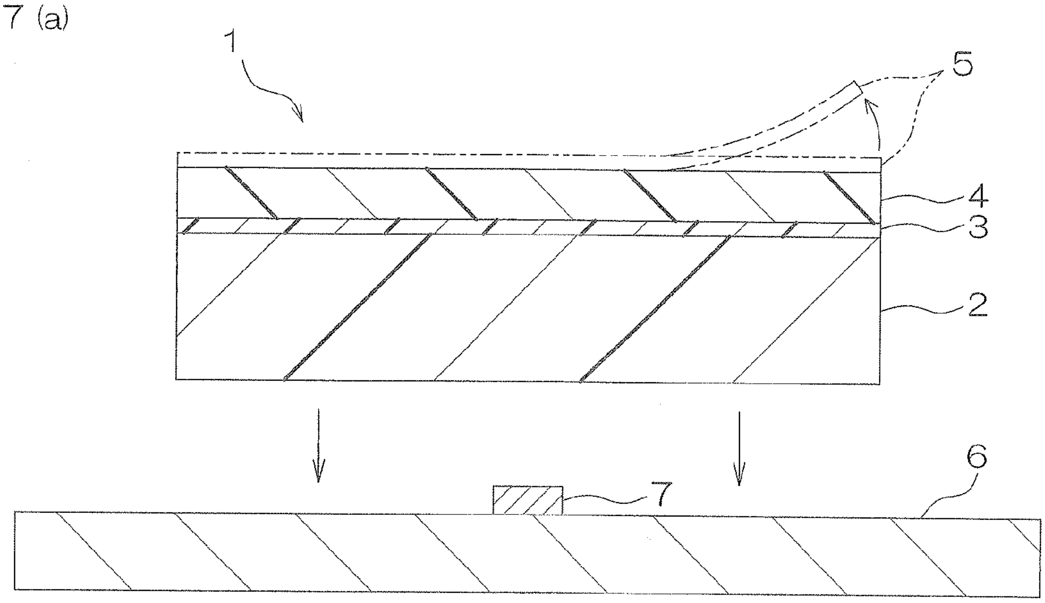


FIG. 7(b)

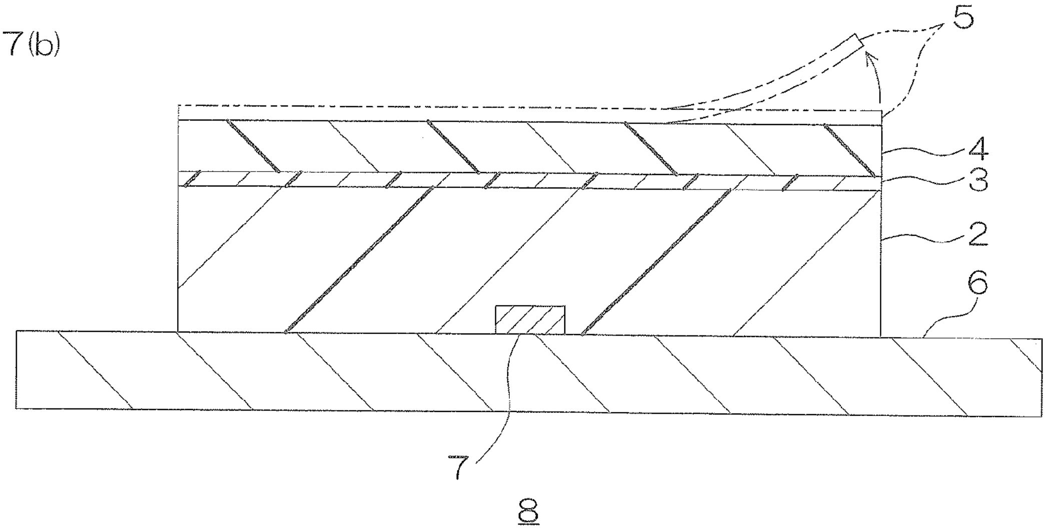

FIG. 8

FIG. 8 (a)

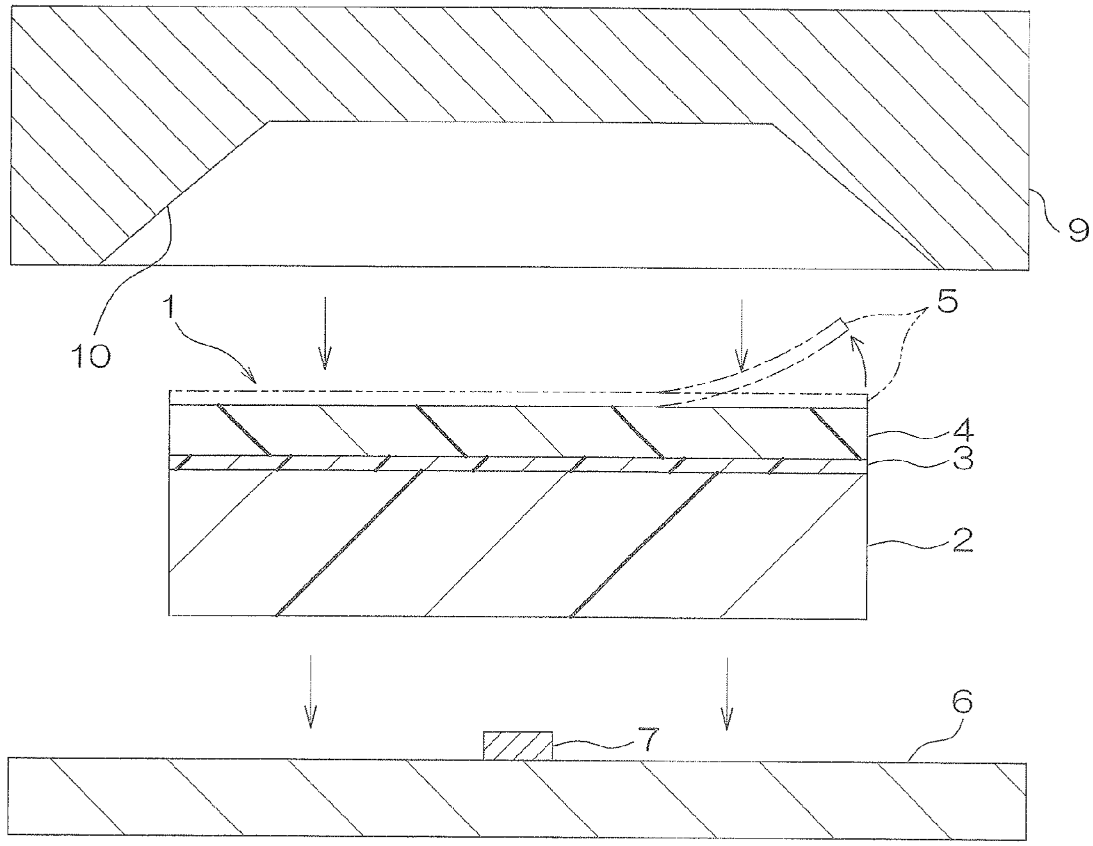


FIG. 8(b)

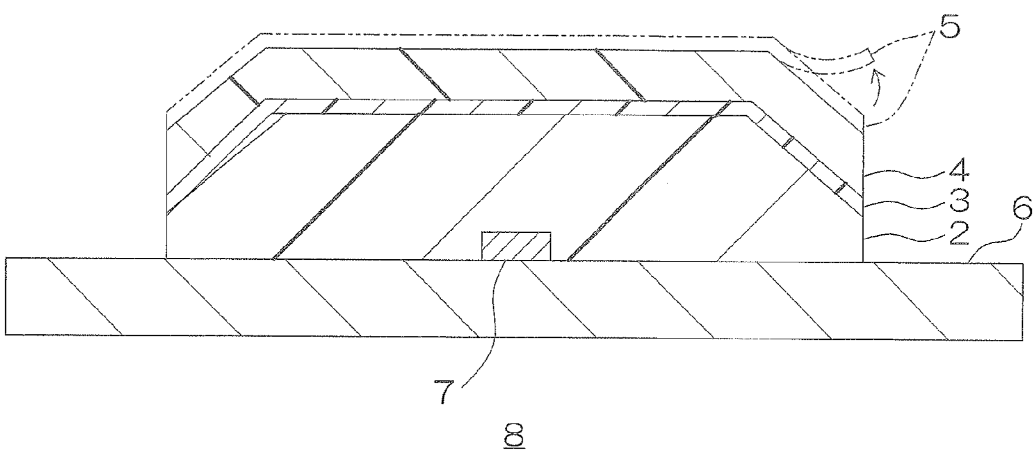

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2012132238 A
- JP 2001358368 A